Europäisches Patentamt

**European Patent Office**

**Office européen des brevets**

(19)

(11) Publication number: **0 404 137**
**A2**

# EUROPEAN PATENT APPLICATION

(12)

(21) Application number: **90111707.7**

(51) Int. Cl.⁵: **H03F 3/60**

(22) Date of filing: **21.06.90**

(30) Priority: **21.06.89 IT 4810389**

(43) Date of publication of application:
**27.12.90 Bulletin 90/52**

(84) Designated Contracting States:
**AT DE FR GB NL SE**

(71) Applicant: **SELENIA SPAZIO S.p.A.**
**via Pile, 60**
**I-67100 L'Aquila(IT)**

(72) Inventor: **Laura, Carlo**
**Via Palestrina n. 29**
**I-00189 Roma(IT)**

(74) Representative: **Gustorf, Gerhard, Dipl.-Ing.**
**Patentanwalt Dipl.-Ing. Gerhard Gustorf**
**Bachstrasse 6 A**
**D-8300 Landshut(DE)**

(54) **Biomode balanced amplifier.**

(57) The invention consists basically of a balanced amplifier made up of two identical amplifying elements and of two 3 dB couplers, one at the input and one at the output, having identical characteristics, but not necessarily of the same nature in terms of structure.

The amplifier is completed by a direct interconnection of port $3'$ of the output coupler and port 4 of the input coupler.

Contrarily to a normal balanced amplifier where the signal input to port 1 is picked up amplified by a factor G (or GdB in deciBels) at port $3'$, and where ports $2'$ and 4 are closed on matched loads, in this amplifier the amplified signal at port $3'$ is re-introduced into port 4 of the input coupler and is therefore subject to the amplification process a second time and is available at port $2'$ of the output coupler with a gain factor of $G^2$ (or 2 GdB) yet maintaining the same peak power as that of the two paralleled elements and their same bandwidth.

This is possible because the gain increase is not obtained by means of a positive feedback effect, but rather by two independent modes, i.e. the sum and the difference modes of the two amplifying elements.

It fact, in conditions of linearity, ports 4 and $3'$ and 1 and $2'$ are decoupled, so that if the balancing is well done no positive feedback takes place.

FIG. 1

## Bimode balanced amplifier

The invention regards a bimode balanced microwave amplifier which finds its best application in microwave equipment, such as the transmitter part of a radar. The invention belongs to the microwave device field and more generally to that of telecommunications systems.

The problem faced and solved by this invention was previosly solved by adopting two similar cascaded stages.

The proposed amplifier increases the gain of a single balanced amplifier so as to make it comparable to that of a cascade of the two.

The advantages of the device presented, when compared with previous solutions are the reduction of weight, size and power consumption and production and maintenance cost savings therefore follow.

The invention will now be described for non limiting descriptive purposes with reference to the tables of figures attached.

Figure 1 shows the bimode balanced amplifier made up of a balanced amplifier, in turn made up of a quadrature 3dB coupler a″ with ports 1,2,3 & 4; of two identical amplifiers having gain G; of a quadrature coupler a″ identical to the previous one and indicated as 1′,2′,3′&4′. Line 5 which connects port 3′ of coupler a″ to port 4 of coupler a′ is the innovative aspect of this invention.

Figure 2 shows the equivalence in terms of gain of two cascaded balanced amplifiers and the bimode amplifier.

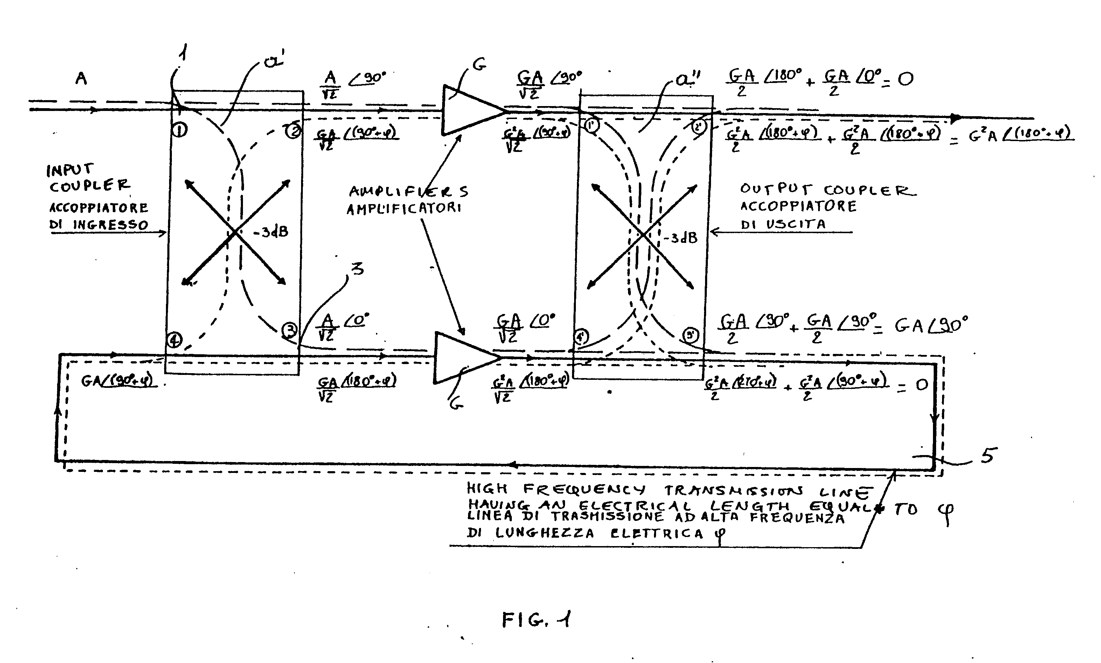

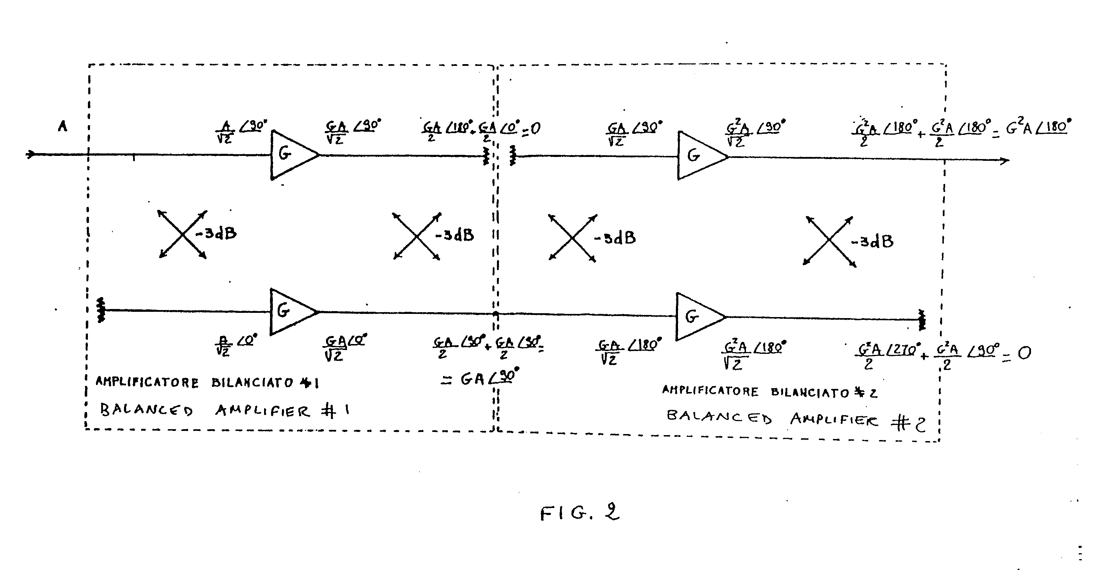

As the comparison of Figure 1 and 2 shows, the bimode amplifier gain is obtained adopting only two amplifier elements rather than four.

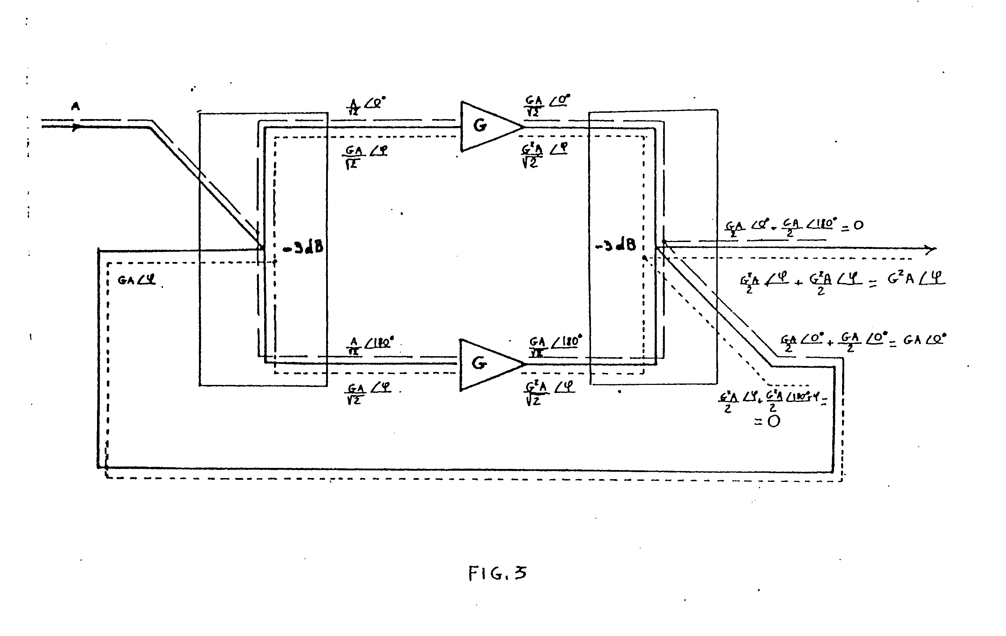

Figure 3 extends the validity of the schematic. where the difference compared to Figure 1 is in the adoption of in phase and quadrature couplers rather than quadrature couplers.

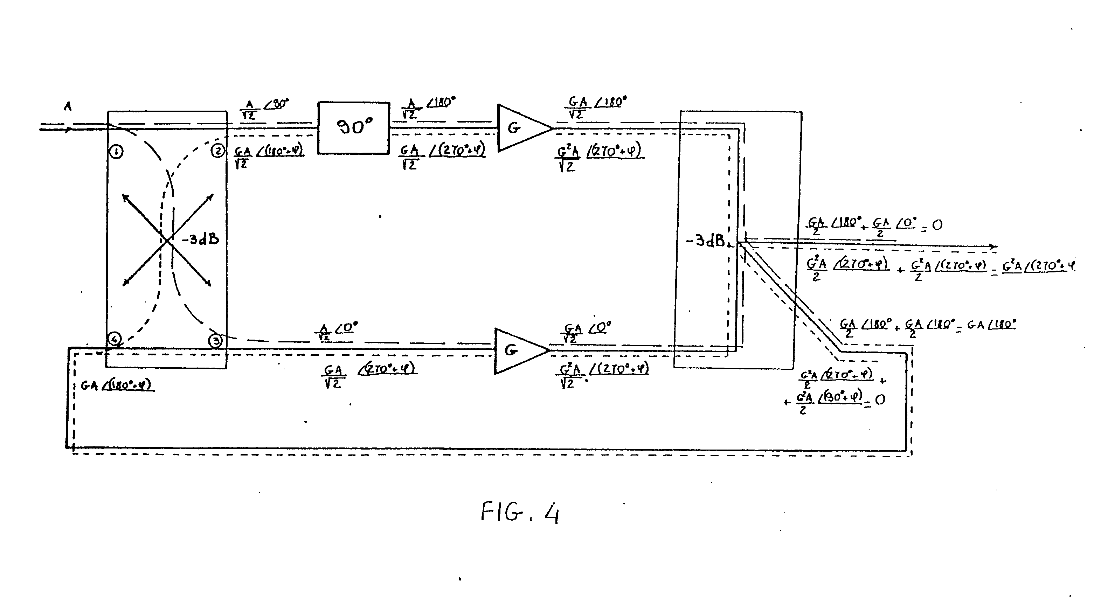

Figure 4 illustrates a possible variation of the invention compared to that shown in Figure 1. It can be seen that in the quadrature coupler input, a 90 deg phase shifter has been added, which serves to take the two output signals of the coupler in phase or in phase opposition depending on the input port selected. As in the case of figure 3, a phase and antiphase coupler has been adopted.

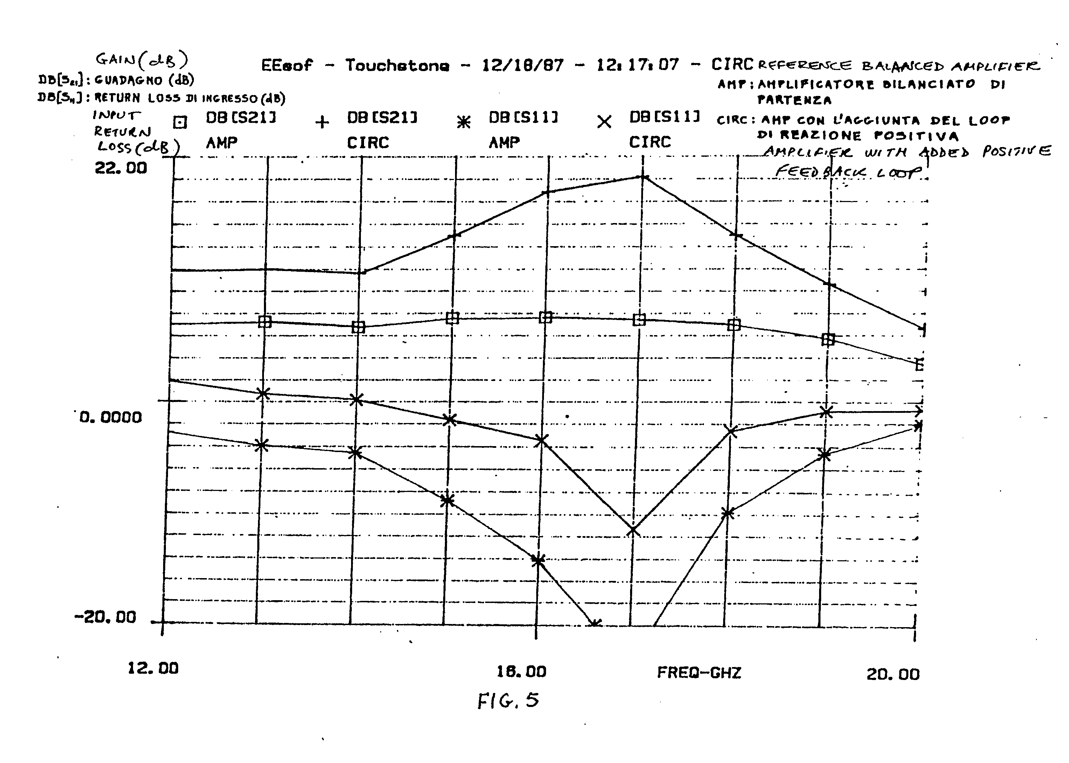

Figure 5 shows the diagram of a simulation of the bimode amplifier and compares it to the balanced amplifier we started with. This is to say that the simulation started with a traditional type of balanced amplifier having a gain curve indicated by a square (□): the line indicated as 5 in Figure 1 was then added and it was thjen transformed into a bimode amplifier having a gain curve as that indicated by the plus sign (+). Reflection coefficients are indicated by the asterisc (*) when referred to the balanced amplifier and by a multiply sign (x) in the case of the bimode amplifier.

With reference to figure 1, lets now consider a generic signal A at a microwave or RF frequency equal to:

$$A = \underset{\sim}{A}\, e^{j(\omega t + \vartheta)}$$

where

$$\underset{\sim}{A}$$

is the module of the amplitude of the signal
w is the pulsation $= 2\pi f$ (where f is the signal frequency)
$\vartheta$ is the initial phase of the signal.

Signal A as defined above is input into port 1 of the 3 dB input coupler, and from ports 2 and 3 of the coupler we have the following two signals:

$$\frac{A}{\sqrt{2}} \angle 90° \quad \text{and} \quad \frac{A}{\sqrt{2}} \angle 0°$$

The two signals then cross the two identical elementary amplifiers each having gain G, so that at the output we have:

$$\frac{GA}{\sqrt{2}} \angle 90° \qquad \text{and} \qquad \frac{GA}{\sqrt{2}} \angle 0°$$

For ease of representation the phase shift introduced by the amplifiers or plumbing components is not taken into consideration as being equal in the two routs do not contribute to relative phasing of the signals.

The two signals are then introduced to ports 1' and 4' of the output coupler.

The combination on port 2' is in antiphase and the resultilng signal is therefore null. On port 3' the two signals combine in phase and their sum is given by:

$$\frac{GA}{2} \angle 90° + \frac{GA}{2} \angle 90° = GA \angle 90°$$

Up till this point the description does not move away from that of a balanced amplifier.

With the difference that port 3' of the output coupler is used as output port, while here a connection between this port and port 4 of the input coupler is made by means of the element which represents the innovative aspect of this invention, consisting of a high frequency line, manufactured as a micro strip, stripline, fin line or suspended substrate or coplanar waveguide or dielectric waveguide or guideline or coaxial or optical fibre etc. depending upon the signal frequency and on related circuit needs and having an electrical length equal to:

$$\varphi = \frac{360 \, \ell}{\lambda}$$

where $l$ = phisical length of the line
$\lambda$ = wavelength associated to the signal frequency which takes consideration for the transmissive means characteristics.

On port 4 of the input coupler the sum signal is phase shifted by the electrical length of the line, ie.:

$$GA \angle 90° + \varphi$$

On ports 2 and 3 of the input coupler we obtain the following two signals respectively:

$$\frac{GA}{\sqrt{2}} \angle 90° + \varphi \qquad \text{and} \qquad \frac{GA}{\sqrt{2}} \angle 180° + \varphi$$

which when amplified become:

$$\frac{G^2 A}{\sqrt{2}} \angle 90° + \varphi \quad \text{and} \quad \frac{G^2 A}{\sqrt{2}} \angle 180° + \varphi$$

The two signals are then sent to the output coupler, in this case they are in opposite phase on port 3' and cancellation takes place on this port.

On port 2' on the contrary in phase combination of the two signals takes place.

$$\frac{G^2 A}{2} \angle 180° + \varphi + \frac{G^2 A}{2} \angle 180° + \varphi = G^2 A \angle 180° + \varphi$$

It is of immediate verification that with the schematic proposed the signal obtained at the output is six times that obtained by means of a normal balanced amplifier.

The circuit proposed is equivalent in terms of gain to a cascade of two identical balanced stages. The schematic shows in figure 2 takes this last case into consideration and it provides an identical result.

The insertion schematic of the amplifier may also be implemented by different types of 3 dB couplers.

Figure 3 shows a schematic similar to that of Figure 1 which makes use of two magic tees or two rat race hybrids as output and input couplers.

Figure 4 shows the input coupler formed by a quadrature hybrid connected through port 2 to a fixed 90 deg phase shifter, so that the signals coming from the two output ports are in phase or in anti phase according to whether port 4 or 1 is used as input port. The schematic indicates a magic T as output coupler.

Figure 5 finally shows the computer simulated plotting of the amplifier of interest here. Such simulation is based upon the simulated connection between the input and output couplers and adding it to the simulation of an existing balanced amplifier. The plotting shows the gain and return loss variations as a function of frequency of the amplifier of interest to this patent application and of the existing balanced amplifier.

The simulation over a wide bandwidth shows that the gain of the proposed circuit is always above that of the reference balanced amplifier.

The performance differences compared to the theoretical are due to the reference balanced amplifier input reflection coefficient, which is rather high.

The addition of a direct connection between the output coupler port, usually meant for the signal output and the input coupler port, usually not adopted and closed upon a matched load in a balanced amplifier schematic, confers the following characteristics to the resulting amplifier:
- gain equal to that obtainable by two balanced stages identical to the cascaded reference one .
- at equal power output of the reference balanced amplifier, the power dissipated in the active devices is lower in the schematic proposed.
- at equal linear gain compared to other amplification stages, the proposed circuit solution offers:
-lower power consumption
-lower weight
-smaller dimensions.

## Claims

1. Microwave balanced amplifier consisting of two identical amplifiers and two 3 dB directional couplers a' and a'' at the output and input, having identical charactristics, and specifically equipped with a connection of one of the output ports with the input port decoupled from the signal so as to utilize the pair of amplifiers twice by exciting them in two indipendent modes, where the output power available is equal to that of the parallel of two amplifier elements and the resulting amplification is equal to that of the cascade of the two amplifiers.

2. Amplifier as per the claim above, which can be used at any frequency at which it is required to utilize balanced stages with high amplification without positive reaction.

3. Bimode amplifier which can be configured in different manners according to whether it adopts quadrature or in phase couplers and phase opposition (Figure 3).

4. Bimode amplifier which has a mixed coupler configuration, one in quadrature with a 90 deg phase shifter and the other in phase and quadrature.

FIG. 1

EP 0 404 137 A2

A

$$\frac{A}{\sqrt{2}} \angle 90° \qquad \frac{GA}{\sqrt{2}} \angle 90° \qquad G \qquad \frac{GA}{2} \angle 180° + \frac{GA}{2} \angle 0° = 0 \qquad \frac{GA}{\sqrt{2}} \angle 90° \qquad \frac{G^2A}{\sqrt{2}} \angle 90° \qquad \frac{G^2A}{2} \angle 180° + \frac{G^2A}{2} \angle 180° = G^2A \angle 180°$$

-3dB  -3dB  -3dB  -3dB

$$\frac{A}{\sqrt{2}} \angle 0° \qquad \frac{GA}{\sqrt{2}} \angle 0° \qquad \frac{GA}{2} \angle 90° + \frac{GA}{2} \angle 90° = GA \angle 90° \qquad \frac{GA}{\sqrt{2}} \angle 180° \qquad \frac{G^2A}{\sqrt{2}} \angle 180° \qquad \frac{G^2A}{2} \angle 270° + \frac{G^2A}{2} \angle 90° = 0$$

AMPLIFICATORE BILANCIATO #1
BALANCED AMPLIFIER #1

AMPLIFICATORE BILANCIATO #2
BALANCED AMPLIFIER #2

FIG. 2

EP 0 404 137 A2

A

$$\frac{A}{\sqrt{2}} \angle 0°$$

$$\frac{GA}{\sqrt{2}} \angle 0°$$

G

$$\frac{GA}{\sqrt{2}} \angle \varphi$$

$$\frac{G^2A}{\sqrt{2}} \angle \varphi$$

$$-3dB$$

$$GA \angle \varphi$$

$$\frac{GA}{2} \angle 0° + \frac{GA}{2} \angle 180° = 0$$

$$\frac{G^2A}{2} \angle \varphi + \frac{G^2A}{2} \angle \varphi = G^2A \angle \varphi$$

$$\frac{A}{\sqrt{2}} \angle 180°$$

$$\frac{GA}{\sqrt{2}} \angle 180°$$

$$\frac{GA}{\sqrt{2}} \angle \varphi$$

$$\frac{G^2A}{\sqrt{2}} \angle \varphi$$

$$-3dB$$

$$\frac{GA}{2} \angle 0° + \frac{GA}{2} \angle 0° = GA \angle 0°$$

$$\frac{G^2A}{2} \angle \varphi + \frac{G^2A}{2} \angle 180°+\varphi = 0$$

FIG. 3

FIG. 4

EP 0 404 137 A2

GAIN (dB)
DB[S₂₁]: GUADAGNO (dB)
DB[Sₙ]: RETURN LOSS DI INGRESSO (dB)

INPUT RETURN LOSS (dB)

EEsof — Touchstone — 12/18/87 — 12:17:07 — CIRC REFERENCE BALANCED AMPLIFIER

AMP: AMPLIFICATORE BILANCIATO DI PARTENZA

CIRC: AMP CON L'AGGIUNTA DEL LOOP DI REAZIONE POSITIVA

AMPLIFIER WITH ADDED POSITIVE FEEDBACK LOOP

| □ DB[S21] AMP | + DB[S21] CIRC | * DB[S11] AMP | × DB[S11] CIRC |

22.00

0.0000

-20.00

12.00                    18.00        FREQ-GHZ        20.00

FIG. 5

EP 0 404 137 A2